(19) Europäisches Patentamt
European Patent Office
Office européen des brevets

(11) **EP 2 750 576 B1**

(12) **EUROPÄISCHE PATENTSCHRIFT**

(45) Veröffentlichungstag und Bekanntmachung des Hinweises auf die Patenterteilung:
**26.10.2016  Patentblatt 2016/43**

(21) Anmeldenummer: **12759038.8**

(22) Anmeldetag: **27.08.2012**

(51) Int Cl.:
*A47L 9/28* (2006.01)     *G01R 31/36* (2006.01)

(86) Internationale Anmeldenummer:
**PCT/EP2012/066606**

(87) Internationale Veröffentlichungsnummer:
**WO 2013/030154 (07.03.2013 Gazette 2013/10)**

(54) **VORRICHTUNG UND VERFAHREN ZUR ANZEIGE EINER RESTLAUFZEIT EINES AKKUSTAUBSAUGERS**

DEVICE AND METHOD FOR DISPLAYING THE REMAINING RUN TIME OF A BATTERY VACUUM CLEANER

DISPOSITIF ET METHODE POUR AFFICHER LE TEMPS DE FONCTIONNEMENT RESTANT D'UN ASPIRATEUR À BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.08.2011   DE 102011081842**

(43) Veröffentlichungstag der Anmeldung:
**09.07.2014   Patentblatt 2014/28**

(73) Patentinhaber: **BSH Hausgeräte GmbH**
**81739 München (DE)**

(72) Erfinder: **KRAFT, Stefan**
**36151 Burghaun (DE)**

(56) Entgegenhaltungen:
**WO-A1-2004/041054     WO-A1-2010/045588**
**WO-A2-2004/032696     JP-A- 2011 102 806**
**US-B1- 6 484 110**

## Beschreibung

### Hintergrund der Erfindung

Die vorliegende Erfindung betrifft eine Vorrichtung und ein Verfahren zur Anzeige einer Restlaufzeit eines durch einen Akkumulator betriebenen Staubsaugers. Ferner betrifft die Erfindung einen Staubsauger mit einer solchen Vorrichtung sowie ein Ladegerät für einen Staubsauger mit einer solchen Vorrichtung.

### Stand der Technik

Herkömmlicherweise wird der Lade- oder Entladezustand eines Akkustaubsaugers beispielsweise durch Leuchtdioden angezeigt. Die Leuchtdioden können mehrfarbig oder auch mehrsegmentig sein. Eine alternative Möglichkeit zur Anzeige des Lade- oder Entladezustands des Akkustaubsaugers ist die Verwendung eines LCD-Displays oder einer Balkenanzeige.

Herkömmliche Anzeigevorrichtungen für akkubetriebene Geräte sind aus der US 2008/ 0 133 054 A1 und der KR 10 2006 064 330 A bekannt.

Weiter ist die JP 2011 102 806 A bekannt, welche eine Vorrichtung zur Anzeige einer Restlaufzeit offenbart, mit einem Akkumulator, wobei diese Vorrichtung zur Anzeige einer Restlaufzeit eines durch eine Akkumulator betriebenen Staubsauger geeignet ist.

### Der Erfindung zugrundeliegende Aufgabe

Vor diesem Hintergrund besteht eine Aufgabe der vorliegenden Erfindung darin, eine verbesserte Anzeigevorrichtung für einen Akkustaubsauger bereitzustellen.

### Erfindungsgemäße Lösung

Die Bezugszeichen in sämtlichen Ansprüchen haben keine einschränkende Wirkung, sondern sollen lediglich deren Lesbarkeit verbessern.

Die Lösung der gestellten Aufgabe gelingt durch eine Vorrichtung mit den Merkmalen des Anspruchs 1 und durch einen Akkustaubsauger mit den Merkmalen des Anspruchs 12.

Erfindungsgemäß wird eine Vorrichtung zur Anzeige einer Restlaufzeit eines durch einen Akkumulator betriebenen Staubsaugers vorgeschlagen, welche eine Ermittlungseinheit, eine Bestimmungseinheit, eine Berechnungseinheit und eine Anzeigeeinrichtung aufweist. Die Ermittlungseinheit ist zum Ermitteln einer aktuell verfügbaren elektrischen Energie des Akkumulators eingerichtet. Die Bestimmungseinheit ist zum Bestimmen der aktuellen Leistungsaufnahme des Staubsaugers eingerichtet. Die Berechnungseinheit ist zum Berechnen der Restlaufzeit in Abhängigkeit der ermittelten aktuell verfügbaren elektrischen Energie und der bestimmten aktuellen Leistungsaufnahme eingerichtet. Die Anzeigeeinrichtung ist zum Anzeigen der berechneten Restlaufzeit als Klartext eingerichtet.

Erfindungsgemäß ist die Bestimmungseinheit weiter dazu eingerichtet, die aktuelle Leistungsaufnahme des Staubsaugers in Abhängigkeit einer eingestellten diskreten Leistungsstufe des Leistungsreglers des Staubsaugers zu bestimmen.

Insbesondere bei Vorhandensein von diskreten Leistungsstufen kann die jeweilige eingestellte diskrete Leistungsstufe als Parameter für die jeweilige aktuelle Leistungsaufnahme verwendet werden. Die Leistungsstellung kann zwei- oder mehrstufig erfolgen. Alternativ kann die Leistungsstelle über ein Potentiometer erfolgen.

Durch die erfindungsgemäße Anzeige der berechneten Restlaufzeit als Klartext erhält der Nutzer des Akkustaubsaugers eine direkte und unmittelbare Anzeige der Restlaufzeit. Des Weiteren ist durch die erfindungsgemäße Anzeige der Restlaufzeit als Klartext dem Nutzer nicht nur eine qualitative, sondern auch eine quantitative Aussage über die mögliche Nutzungsdauer des Akkustaubsaugers bereitgestellt. Der Nutzer kann somit unmittelbar abschätzen, ob die aktuelle Akkuladung des Akkustaubsaugers noch für eine bestimmte Säuberung ausreicht oder ob der Akkustaubsauger zeitlich entsprechend geladen werden muss. Insbesondere noch während des Ladevorgangs des Akkustaubsaugers kann der Nutzer durch eine jeweils aktualisierte Anzeige der Restlaufzeit als Klartext erkennen, wie lange die jeweilige Akkuladung ausreicht.

Die Vorrichtung kann auch als Anzeigevorrichtung oder als Restlaufanzeigevorrichtung bezeichnet werden. Unter einem Staubsauger sind mit elektrischer Energie betriebene Geräte zur Aufnahme von Staub zu verstehen, wobei insbesondere Batterie- oder Akku-Geräte eingeschlossen sind.

Ferner wird ein Staubsauger mit einer wie oben beschriebenen Vorrichtung zur Klartext-Anzeige einer Restlaufzeit eines Akkumulators des Staubsaugers vorgeschlagen.

### Bevorzugte Ausgestaltungen der Erfindung

Vorteilhafte Aus- und Weiterbildungen, welche einzeln oder in Kombination miteinander eingesetzt werden können, sind Gegenstand der abhängigen Ansprüche.

Bei einer Ausführungsform der Vorrichtung ist eine Steuervorrichtung vorgesehen, welche die Ermittlungseinheit, die Bestimmungseinheit und die Berechnungseinheit integriert.

Die Steuervorrichtung ist insbesondere als Microcontroller ausgebildet, welcher zum Steuern des Akkustaubsaugers eingerichtet ist.

Bei einer weiteren Ausführungsform weist die Steuervorrichtung eine Nachschlagtabelle auf. Die Nachschlagtabelle speichert eine Vielzahl von Zuordnungen von einem jeweiligen bestimmten Wertepaar aus der elektrischen Energie des Akkumulators und der Leistungsaufnahme des Staubsaugers auf eine jeweilige bestimmte Restlaufzeit.

Das heißt, aus der jeweiligen aktuellen elektrischen Energie des Akkumulators und der jeweiligen aktuellen Leistungsaufnahme des Staubsaugers kann ein jeweiliges Wertepaar gebildet werden, welches als Eingabe für die Nachschlagtabelle dient. Die Nachschlagtabelle gibt nach Eingabe des jeweiligen bestimmten Wertepaares eine diesem bestimmten Wertepaar zugeordnete bestimmte Restlaufzeit zurück.

Bei einer weiteren Ausführungsform ist die Steuervorrichtung dazu eingerichtet, einen aktuellen Ladezustand des Akkumulators zu einem ersten Zeitpunkt zu ermitteln, die aktuell verfügbare elektrische Energie des Akkumulators zu dem ersten Zeitpunkt aus dem ermittelten aktuellen Ladezustand zu ermitteln, eine Einschaltdauer des Staubsaugers zwischen dem ersten Zeitpunkt und einem zweiten Zeitpunkt zu messen, die Restlaufzeit zu dem ersten Zeitpunkt mittels der Nachschlagtabelle, der ermittelten aktuell verfügbaren elektrischen Energie zu dem ersten Zeitpunkt und der bestimmten aktuellen Leistungsaufnahme zu dem ersten Zeitpunkt zu bestimmen, und die Restlaufzeit zu dem zweiten Zeitpunkt durch eine Differenz zwischen der bestimmten Restlaufzeit zu dem ersten Zeitpunkt und der gemessenen Einschaltdauer zu berechnen.

Bei einer weiteren Ausführungsform ist Anzeigeeinrichtung dazu eingerichtet, die berechnete Restlaufzeit als einen numerischen Wert anzuzeigen.

Der numerische Wert ist beispielsweise als eine Minutenanzeige, als eine Minuten- und Sekundenanzeige oder als eine Stunden-, Minuten- und Sekundenanzeige ausgebildet. Somit kann der Nutzer unmittelbar die Restlaufzeit an der Anzeigeeinrichtung ablesen.

Bei einer weiteren Ausführungsform weist die Anzeigeeinrichtung ein LCD-Display (LCD, Liquid Crystal Display) auf.

Bei einer weiteren Ausführungsform ist die Ermittlungseinheit dazu eingerichtet, die aktuell verfügbare Energie des Akkumulators in Abhängigkeit einer gemessenen Spannung des Akkumulators während des Betriebs des Staubsaugers zu ermitteln.

Bei einer weiteren Ausführungsform ist die Ermittlungseinheit dazu eingerichtet, die aktuell verfügbare Energie des Akkumulators in Abhängigkeit der gemessenen Spannung des Akkumulators und eines gemessenen Stroms des Akkumulators während des Betriebs des Staubsaugers zu ermitteln.

Bei einer weiteren Ausführungsform ist die Bestimmungseinheit dazu eingerichtet, die aktuelle Leistungsaufnahme des Staubsaugers in Abhängigkeit einer gemessenen Spannung eines Motors des Staubsaugers und eines gemessenen Stroms des Motors zu ermitteln.

Bei einer weiteren Ausführungsform ist die Anzeigeeinrichtung dazu eingerichtet, die Restlaufzeit und eine zugehörige diskrete Leistungsstufe des Leistungsreglers des Staubsaugers anzuzeigen.

Bei einer weiteren Ausführungsform ist die Berechnungseinheit dazu eingerichtet, eine jeweilige Restlaufzeit für eine jeweilige zugehörige diskrete Leistungsstufe einer Mehrzahl diskreter Leistungsstufen des Leistungsreglers zu berechnen. Bei dieser Ausführungsform wird die Anzeigeeinrichtung insbesondere dazu eingerichtet, die jeweilige berechnete Restlaufzeit mit der jeweiligen zugehörigen diskreten Leistungsstufe anzuzeigen.

Folglich ist dem Nutzer für eine jede diskrete Leistungsstufe, die er durch den Leistungsregler des Akkustaubsaugers einstellen kann, die jeweilige Restlaufzeit als Klartext bereitgestellt.

Die vorliegende Erfindung ermöglicht die Anzeige der berechneten Restlaufzeit des Akkustaubsaugers als Klartext. Somit erhält der Nutzer des Akkustaubsaugers eine direkte und unmittelbare Anzeige der jeweils aktuellen Restlaufzeit, die er einfach von der Anzeigeeinrichtung ablesen kann. Des Weiteren ist durch die erfindungsgemäße Anzeige der Restlaufzeit als Klartext dem Nutzer nicht nur eine qualitative, sondern auch eine quantitative Aussage über die mögliche Nutzungsdauer des Akkustaubsaugers bereitgestellt.

## Kurzbeschreibung der Zeichnungen

Weitere vorteilhafte Ausgestaltungen werden nachfolgend an Hand der in den Zeichnungen dargestellten Ausführungsbeispielen, auf welches die Erfindung jedoch nicht beschränkt ist, näher beschrieben.

Es zeigen dabei:

Fig. 1     eine schematische Ansicht eines Ausführungsbeispiels einer Vorrichtung zur Anzeige einer Restlaufzeit eines Akkustaubsaugers;

Fig. 2     eine schematische Ansicht eines Ausführungsbeispiels eines Akkustaubsaugers;

Fig. 3     eine schematische Ansicht eines weiteren Ausführungsbeispiels eines Akkustaubsaugers;

Fig. 4     eine schematische Ansicht eines Ausführungsbeispiels einer Anzeigeeinrichtung;

Fig. 5     eine schematische Ansicht eines weiteren Ausführungsbeispiels einer Anzeigeeinrichtung;

Fig. 6     eine schematische Ansicht eines Ausführungsbeispiels eines Ladegeräts für einen Akkustaubsauger;

Fig. 7     ein schematisches Ablaufdiagramm eines Ausführungsbeispiels eines Verfahrens zur Anzeige einer Restlaufzeit eines Akkustaubsaugers; und

Fig. 8     ein schematisches Ablaufdiagramm eines weiteren Ausführungsbeispiels eines Verfahrens zur Anzeige einer Restlaufzeit eines Akkustaubsaugers.

## Ausführliche Beschreibung der Ausführungsbeispiele

Bei der nachfolgenden Beschreibung der Ausführungsformen der vorliegenden Erfindung bezeichnen gleiche Bezugszeichen gleiche oder vergleichbare Komponenten.

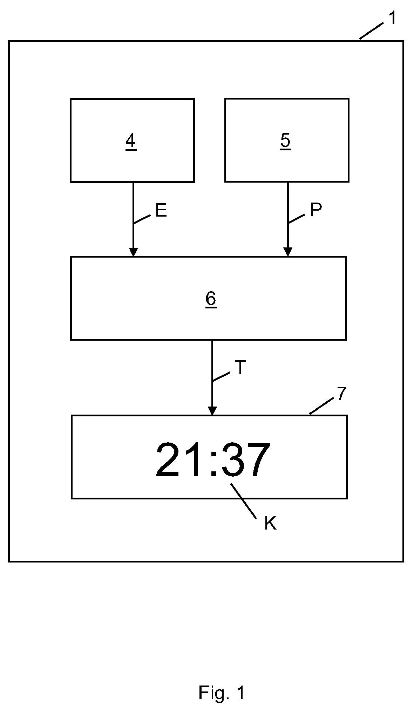

In der Fig. 1 ist eine schematische Ansicht eines Ausführungsbeispiels einer Vorrichtung 1 zur Anzeige einer Restlaufzeit T eines Akkustaubsaugers 3 dargestellt.

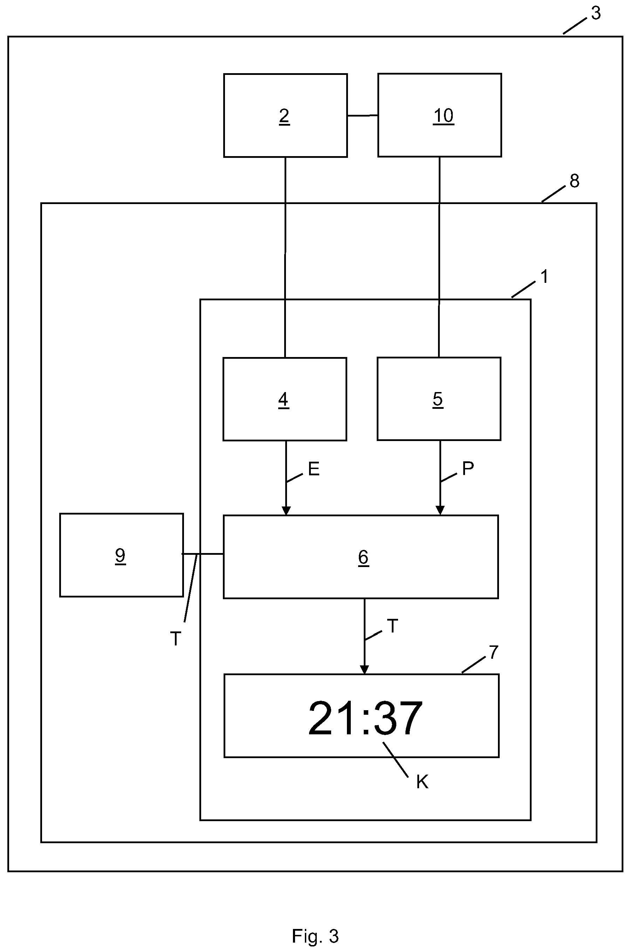

Die Vorrichtung 1 hat eine Ermittlungseinheit 4, eine Bestimmungseinheit 5, eine Berechnungseinheit 6 sowie eine Anzeigeeinrichtung 7. Die Bestimmungseinheit 4 ermittelt die aktuell verfügbare elektrische Energie E des Akkumulators 2. Dazu ist die Ermittlungseinheit 4 mit dem Akkumulator 2 des Staubsaugers 3 gekoppelt (siehe Fig. 3).

Insbesondere ermittelt die Ermittlungseinheit 4 die aktuell verfügbare Energie E des Akkumulators 2 in Abhängigkeit der gemessenen Spannung des Akkumulators 2 und eines gemessenen Stroms des Akkumulators 2 während des Betriebs des Staubsaugers 3. Die Ermittlungseinheit 4 stellt die ermittelte aktuell verfügbare Energie E des Akkumulators 2 der Berechnungseinheit 6 bereit.

Die Bestimmungseinheit 5 bestimmt die aktuelle Leistungsaufnahme P des Staubsaugers 3. Dazu verwendet die Bestimmungseinheit 5 eine aktuell gemessene Spannung eines Motors 10 des Staubsaugers 3 und einen gemessenen Strom des Motors 10 (siehe Fig. 3).

Die Bestimmungseinheit 5 stellt die bestimmte aktuelle Leistungsaufnahme P der Berechnungseinheit 6 bereit. Alternativ kann die Bestimmungseinheit 5 die aktuelle Leistungsaufnahme P des Staubsaugers 3 auch in Abhängigkeit einer eingestellten diskreten Leistungsstufe des Leistungsreglers des Staubsaugers 3 bestimmen. Diese Möglichkeit liegt dann vor, wenn der Staubsauger 3 einen Leistungsregler mit diskreten Leistungsstufen aufweist.

Die Berechnungseinheit 6 berechnet die Restlaufzeit T in Abhängigkeit der ermittelten aktuell verfügbaren elektrischen Energie E und der bestimmten aktuellen Leistungsaufnahme P ($T = \dfrac{E}{P}$).

Die Berechnungseinheit 6 stellt die berechnete Restlaufzeit T der Anzeigeeinrichtung 7 bereit. Die Anzeigeeinrichtung 7 stellt die empfangene berechnete Restlaufzeit T dem Nutzer als Klartext K bereit. In dem Beispiel der Fig. 1 zeigt der Klartext K für die Restlaufzeit T 21:37, d.h. eine Restlaufzeit von 21 min und 37 s. Zur Anzeige des Klartextes K der Restlaufzeit T hat die Anzeigeeinrichtung 7 beispielsweise ein LCD-Display.

Das jeweilige Einheit, nämlich Ermittlungseinheit 4, Bestimmungseinheit 5 und Berechnungseinheit 6, kann hardwaretechnisch oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

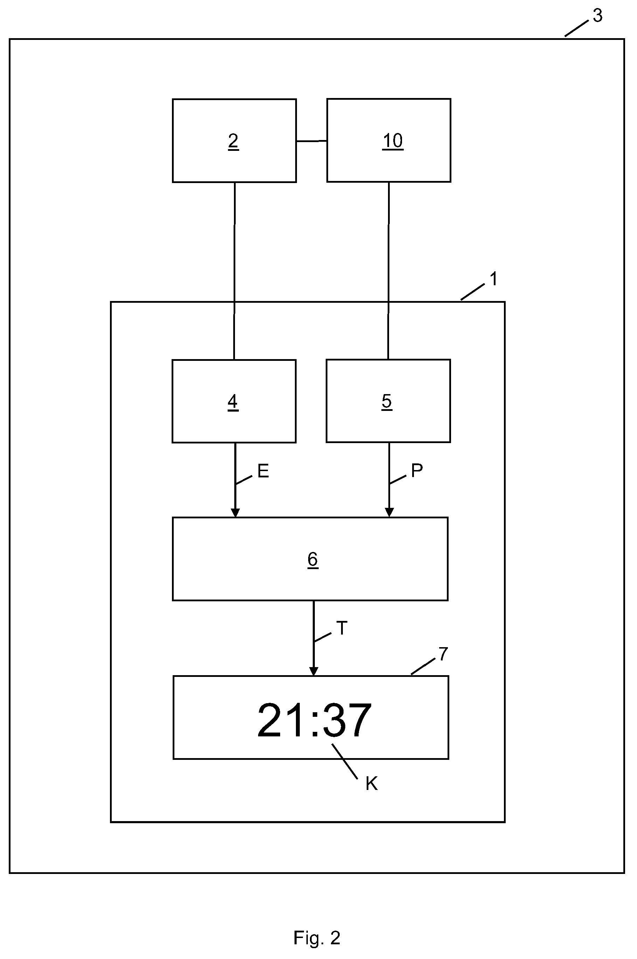

Fig. 2 zeigt eine schematische Ansicht eines Ausführungsbeispiels eines Akkustaubsaugers 3. Der Akkustaubsauger 3 hat einen Akkumulator 2, einen durch den Akkumulator 2 betriebenen Motor 10 und eine Vorrichtung 1 zur Anzeige der Restlaufzeit T des Akkustaubsaugers 3. Die Vorrichtung 1 ist gemäß dem Ausführungsbeispiel der Fig. 1 ausgebildet. Die Ermittlungseinheit 4 ist mit dem Akkumulator 2 gekoppelt, so dass die Ermittlungseinheit 4 die aktuell verfügbare elektrische Energie E des Akkumulators 2 bestimmen kann. Ferner ist die Bestimmungseinheit 5 mit dem Motor 10 des Staubsaugers 3 gekoppelt, so dass die Bestimmungseinheit 5 die aktuelle Leistungsaufnahme P des Staubsaugers 3 bestimmen kann. Alternativ kann die Bestimmungseinheit 5 auch mit dem Leistungsregler des Staubsaugers 3 gekoppelt sein (nicht gezeigt), um in Abhängigkeit einer eingestellten diskreten Leistungsstufe des Leistungsreglers die aktuelle Leistungsaufnahme P des Staubsaugers zu bestimmen.

In Fig. 3 ist eine schematische Ansicht eines weiteren Ausführungsbeispiels eines Akkustaubsaugers 3 dargestellt. Das Ausführungsbeispiel der Fig. 3 unterscheidet sich von dem Ausführungsbeispiel der Fig. 2 dahingehend, dass die Vorrichtung 1 in einer Steuervorrichtung 8 integriert ist. Die Steuervorrichtung 8 ist beispielsweise ein Mikrocontroller zum Steuern des Staubsaugers 3.

Außerdem weist die Steuervorrichtung 8 eine Nachschlagtabelle 9 (LUT, Look Up Table) auf. Die Nachschlagtabelle 9 speichert eine Vielzahl von Zuordnungen von einem jeweiligen bestimmten Wertepaar aus der elektrischen Energie E des Akkumulators 2 und der Leistungsaufnahme P des Staubsaugers auf eine jeweilige bestimmte Restlaufzeit T. Mit anderen Worten liefert die Nachschlagtabelle 9 bei Eingabe eines Wertepaares aus elektrischer Energie E und Leistungsaufnahme P eine bestimmte Restlaufzeit T. Diese Restlaufzeit T kann der Berechnungseinheit 6 bereitgestellt werden, welche diese Restlaufzeit T wiederum der Anzeigeeinrichtung 7 bereitstellen kann.

Des Weiteren kann die Steuervorrichtung 8 auch dazu eingerichtet sein, einen aktuellen Ladezustand des Akkumulators 2 zu einem ersten Zeitpunkt zu ermitteln. Ferner ist die Steuervorrichtung 8 dann dazu eingerichtet, die aktuell verfügbare elektrische Energie E des Akkumulators 2 zu dem ersten Zeitpunkt aus dem ermittelten aktuellen Ladezustand zu ermitteln. Weiter ist die Steuervorrichtung 8 dazu eingerichtet, eine Einschaltdauer des Staubsaugers 3 zwischen dem ersten Zeitpunkt und einem zweiten Zeitpunkt zu messen. Dabei entspricht der zweite Zeitpunkt dem Zeitpunkt, an dem die Restlaufzeit T dem Nutzer durch die Anzeigeeinrichtung 7 angezeigt werden soll. Dazu wird die Restlaufzeit zu dem ersten Zeitpunkt mittels der Nachschlagtabelle 9, der ermittelten aktuell verfügbaren Energie E zu dem ersten Zeitpunkt und der bestimmten aktuellen Leistungsaufnahme P zu dem ersten Zeitpunkt bestimmt. Die Restlaufzeit zu dem zweiten Zeitpunkt wird dann durch eine Differenzbildung zwischen der bestimmten Restlaufzeit zu dem ersten Zeitpunkt und der gemessenen Einschaltdauer durch die Steuervorrichtung 8 berechnet.

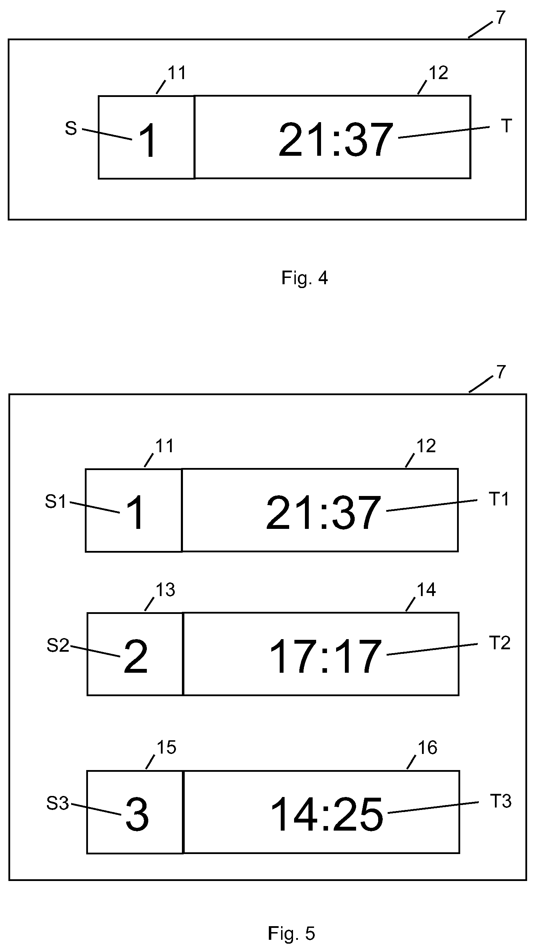

In Fig. 4 ist eine schematische Ansicht eines Ausführungsbeispiels eine Anzeigeeinrichtung 7 für die Vorrichtung 1 zur Anzeige der Restlaufzeit T des Akkustaubsaugers 3 dargestellt. Die Anzeigeeinrichtung 7 der Fig. 4 ist dazu eingerichtet, die Restlaufzeit T und eine zugehörige diskrete Leistungsstufe S des Leistungsreglers des Staubsaugers 3 anzuzeigen. Dazu hat die Anzeigeeinrichtung 7 ein erstes Anzeigefeld 11 zur Anzeige der aktuell eingestellten Leistungsstufe S, hier die Leistungsstufe 1 (S = 1). Ferner hat die Anzeigeeinrichtung 7 ein zweites Anzeigefeld 12 zur Anzeige der Restlaufzeit T bei der angezeigten Leistungsstufe. Gemäß dem Beispiel der Fig. 4 ist die Restlaufzeit T 21:37, d.h. 21 min und 37 s, bei der eingestellten Leistungsstufe 1.

Fig. 5 zeigt eine schematische Ansicht eines weiteren Ausführungsbeispiels einer Anzeigeeinrichtung 7. Die Anzeigeeinrichtung 7 der Fig. 5 ist dazu eingerichtet, eine jeweilige Restlaufzeit T1, T2, T3 für eine jeweilige zugehörige diskrete Leistungsstufe S1, S2, S3 einer Mehrzahl diskreter Leistungsstufen S1, S2, S3 des Leistungsreglers des Staubsaugers 3 anzuzeigen. In dem Beispiel der Fig. 5 hat der Leistungsregler des Staubsaugers 3 drei Leistungsstufen S1, S2 und S3. Die Leistungsstufen S1, S2, S3 werden in den Anzeigefeldern 11, 13 und 15 angezeigt. Dem jeweiligen Anzeigefeld für die Leistungsstufe ist ein Anzeigefeld 12, 14, 16 zur Anzeige der jeweiligen Restlaufzeit T1, T2, T3 zugeordnet. Demnach ist dem Anzeigefeld 11 zur Anzeige der Leistungsstufe S1 ein Anzeigefeld 12 zur Anzeige der Restlaufzeit von 21:37 zugeordnet (S1 = 1, T1 = 21:37 min). Ferner ist dem Anzeigefeld 13 zur Anzeige der zweiten Leistungsstufe S2 das Anzeigefeld 14 zur Anzeige der Restlaufzeit T2 bei der zweiten Leistungsstufe S2 zugeordnet (S2 = 2, T2 = 17:27 min). Entsprechend ist dem Anzeigefeld 15 zur Anzeige der dritten Leistungsstufe S3 das Anzeigefeld 16 zur Anzeige der diesbezüglichen Restlaufzeit T3 zugeordnet (S3 = 3, T3 = 14:26 min).

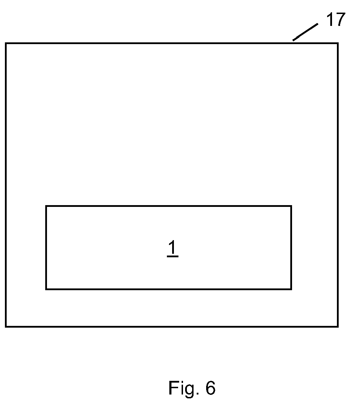

In Fig. 6 ist eine schematische Ansicht eines Ausführungsbeispiels eines Ladegeräts 17 für einen Akkustaubsauger 3 dargestellt. Das Ladegerät 17 hat eine Ladevorrichtung 18 zum Laden des Akkustaubsauger 3 und eine Vorrichtung 1 zur Anzeige der Restlaufzeit T des Akkumulators 2 des Akkustaubsaugers 3. Dazu ist die Vorrichtung 1 mit der Ladevorrichtung 18 gekoppelt.

Die Vorrichtung 1 entspricht beispielsweise dem Ausführungsbeispiel der Fig. 1.

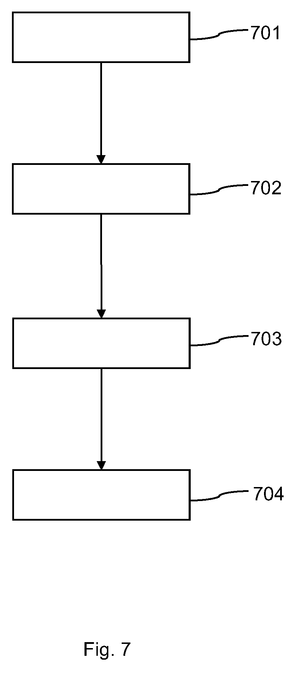

In Fig. 7 ist ein schematisches Ablaufdiagramm eines Ausführungsbeispiels eines Verfahrens zur Anzeige einer Restlaufzeit eines Akkumulators dargestellt.

In Schritt 701 wird die aktuell verfügbare elektrische Energie des Akkumulators des Akkustaubsaugers ermittelt.

In Schritt 702 wird die aktuelle Leistungsaufnahme des Akkustaubsaugers bestimmt.

In Schritt 703 wird die Restlaufzeit des Akkustaubsaugers in Abhängigkeit der ermittelten aktuell verfügbaren Energie und der bestimmten aktuellen Leistungsaufnahme berechnet.

In Schritt 704 wird die berechnete Restlaufzeit als Klartext, zum Beispiel als numerischer Wert mit einer Minuten- und einer Sekundenangabe, angezeigt. Zur Anzeige wird beispielsweise ein LCD-Display eingesetzt, der in dem Gehäuse des Akkustaubsaugers integriert ist.

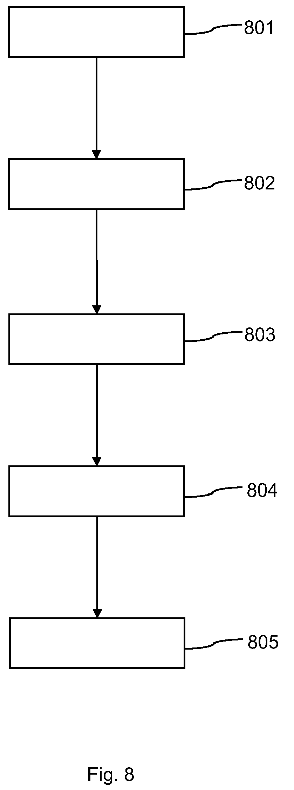

Fig. 8 zeigt ein schematisches Ablaufdiagramm eines weiteren Ausführungsbeispiels eines Verfahrens zur Anzeige der Restlaufzeit eines Akkustaubsaugers.

In Schritt 801 wird der aktuelle Ladezustand des Akkumulators des Akkustaubsaugers zu einem ersten Zeitpunkt ermittelt.

In Schritt 802 wird die aktuell verfügbare elektrische Energie des Akkumulators zu dem ersten Zeitpunkt aus dem ermittelten aktuellen Ladezustand ermittelt.

In Schritt 803 wird die Einschaltdauer des Akkustaubsaugers zwischen dem ersten Zeitpunkt und einem zweiten Zeitpunkt gemessen, zu dem die aktuelle Restlaufzeit angezeigt werden soll.

Dazu wird in Schritt 804 die Restlaufzeit zu dem ersten Zeitpunkt mittels der Nachschlagtabelle, der ermittelten aktuell verfügbaren elektrischen Energie zu dem ersten Zeitpunkt und der bestimmten aktuellen Leistungsaufnahme P zu dem ersten Zeitpunkt bestimmt. Mit anderen Worten wird aus der aktuellen elektrischen Energie E und der aktuellen Leistungsaufnahme P ein Wertepaar gebildet und die diesem Wertepaar zugeordnete Restlaufzeit mittels der Nachschlagtabelle ermittelt.

In Schritt 805 wird dann die Restlaufzeit zu dem zweiten Zeitpunkt durch eine Differenzbildung zwischen der bestimmten Restlaufzeit zu dem ersten Zeitpunkt und der gemessenen Einschaltdauer berechnet.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausgestaltungen von Bedeutung sein.

## Bezugszeichenliste

| 1 | Vorrichtung |
| 2 | Akkumulator |

| | |
|---|---|
| 3 | Staubsauger |
| 4 | Ermittlungseinheit |
| 5 | Bestimmungseinheit |
| 6 | Berechnungseinheit |
| 7 | Anzeigeeinrichtung |
| 8 | Steuervorrichtung |
| 9 | Nachschlagtabelle |
| 10 | Motor |
| 11-16 | Anzeigefeld |
| 17 | Ladegerät |
| 18 | Ladevorrichtung |
| 701-704 | Verfahrensschritt |
| 801-805 | Verfahrensschritt |
| E | Energie |
| K | Klartext der Restlaufzeit |
| P | Leistung |
| S | Leistungsstufe |
| S1 | erste Leistungsstufe |
| S2 | zweite Leistungsstufe |
| S3 | dritte Leistungsstufe |
| T | Restlaufzeit |
| T1 | Restlaufzeit bei der ersten Leistungsstufe |
| T2 | Restlaufzeit bei der zweiten Leistungsstufe |
| T3 | Restlaufzeit bei der dritten Leistungsstufe |

**Patentansprüche**

1. Vorrichtung (1) zur Anzeige einer Restlaufzeit (T; T1, T2, T3) eines durch einen Akkumulator (2) betriebenen Staubsaugers (3), mit einer Ermittlungseinheit (4) zum Ermitteln einer aktuell verfügbaren elektrischen Energie (E) des Akkumulators (2), einer Bestimmungseinheit (5) zum Bestimmen einer aktuellen Leistungsaufnahme (P) des Staubsaugers (3), einer Berechnungseinheit (6) zum Berechnen der Restlaufzeit (T; T1, T2, T3) in Abhängigkeit der ermittelten aktuell verfügbaren elektrischen Energie (E) und der bestimmten aktuellen Leistungsaufnahme (P), und einer Anzeigeeinrichtung (7) zum Anzeigen der berechneten Restlaufzeit (T; T1, T2, T3) als Klartext (K), **dadurch gekennzeichnet, dass** die Bestimmungseinheit (5) dazu eingerichtet ist, die aktuelle Leistungsaufnahme (P) des Staubsaugers (3) in Abhängigkeit einer diskreten eingestellten Leistungsstufe des Leistungsreglers des Staubsaugers (3) zu bestimmen.

2. Vorrichtung nach Anspruch 1, **dadurch gekennzeichnet, dass** eine Steuervorrichtung (8) vorgesehen ist, welche die Ermittlungseinheit (4), die Bestimmungseinheit (5) und die Berechnungseinheit (6) integriert.

3. Vorrichtung nach Anspruch 2, **dadurch gekennzeichnet, dass** die Steuervorrichtung (8) eine Nachschlagtabelle (9) aufweist, welche eine Vielzahl von Zuordnungen von einem jeweiligen bestimmten Wertepaar aus der elektrischen Energie (E) des Akkumulators (2) und der Leistungsaufnahme (P) des Staubsaugers (3) auf eine jeweilige bestimmte Restlaufzeit (T; T1, T2, T3) speichert.

4. Vorrichtung nach Anspruch 3, **dadurch gekennzeichnet, dass** die Steuervorrichtung (8) dazu eingerichtet ist, einen aktuellen Ladezustand des Akkumulators (2) zu einem ersten Zeitpunkt zu ermitteln, die aktuell verfügbare elektrische Energie (E) des Akkumulators (2) zu dem ersten Zeitpunkt aus dem ermittelten aktuellen Ladezustand zu ermitteln, eine Einschaltdauer des Staubsaugers (3) zwischen dem ersten Zeitpunkt und einem zweiten Zeitpunkt zu messen, die Restlaufzeit (T1) zu dem ersten Zeitpunkt mittels der Nachschlagtabelle (9), der ermittelten aktuell verfügbaren elektrischen Energie (E) zu dem ersten Zeitpunkt und der bestimmten aktuellen Leistungsaufnahme (P) zu dem ersten Zeitpunkt zu bestimmen, und die Restlaufzeit (T2) zu dem zweiten Zeitpunkt durch eine Differenz zwischen der bestimmten Restlaufzeit (T1) zu dem ersten Zeitpunkt und der gemessenen Einschaltdauer zu berechnen.

5. Vorrichtung nach einem der Ansprüche 1 bis 4, **dadurch gekennzeichnet, dass** die Anzeigeeinrichtung (7) dazu eingerichtet ist, die berechnete Restlaufzeit (T; T1, T2, T3) als einen numerischen Wert anzuzeigen.

6. Vorrichtung nach einem der Ansprüche 1 bis 5, **dadurch gekennzeichnet, dass** die Anzeigeeinrichtung (7) ein LCD-Display aufweist.

7. Vorrichtung nach einem der Ansprüche 1 bis 6, **dadurch gekennzeichnet, dass** die Ermittlungseinheit (4) dazu eingerichtet ist, die aktuell verfügbare Energie (E) des Akkumulators (2) in Abhängigkeit einer gemessenen Spannung des Akkumulators (2) während des Betriebs des Staubsaugers (3) zu ermitteln.

8. Vorrichtung nach Anspruch 7, **dadurch gekennzeichnet, dass** die Ermittlungseinheit (4) dazu eingerichtet ist, die aktuell verfügbare Energie (E) des Akkumulators (2) in Abhängigkeit der gemessenen Spannung des Akkumulators (2) und eines gemessenen Stroms des Akkumulators (2) während des Betriebs des Staubsaugers (3) zu ermitteln.

9. Vorrichtung nach einem der Ansprüche 1 bis 8, **dadurch gekennzeichnet, dass** die Bestimmungseinheit (5) dazu eingerichtet ist, die aktuelle Leistungsaufnahme (P) des Staubsaugers (3) in Abhängigkeit einer gemessenen Spannung eines Motors (10) des Staubsaugers (3) und eines gemessenen Stroms des Motors (10) zu ermitteln.

**10.** Vorrichtung nach einem der Ansprüche 1 bis 9, **dadurch gekennzeichnet, dass** die Anzeigeeinrichtung (7) dazu eingerichtet ist, die berechnete Restlaufzeit (T; T1, T2, T3) und eine zugehörige diskrete Leistungsstufe (P) des Leistungsreglers des Staubsaugers (3) anzuzeigen.

**11.** Vorrichtung nach einem der Ansprüche 1 bis 10, **dadurch gekennzeichnet, dass** die Berechnungseinheit (6) dazu eingerichtet ist, eine jeweilige Restlaufzeit (T1, T2, T3) für eine jeweilige zugehörige diskrete Leistungsstufe (S1, S2, S3) einer Mehrzahl diskreter Leistungsstufen (S1, S2, S3) des Leistungsreglers zu berechnen, und dass die Anzeigeeinrichtung (7) dazu eingerichtet ist, die jeweilige berechnete Restlaufzeit (T1, T2, T3) mit der jeweiligen zugehörigen diskreten Leistungsstufe (S1, S2, S3) anzuzeigen.

**12.** Staubsauger (3) mit einer Vorrichtung (1) zu Anzeige einer Restlaufzeit (T; T1, T2, T3) eines Akkumulators (2) des Staubsaugers (3) nach einem der Ansprüche 1 bis 11.

**Claims**

**1.** Device (1) for displaying a remaining running time (T; T1, T2, T3) of a vacuum cleaner (3) powered by a battery (2), having a detection unit (4) for detecting electrical energy (E) currently available from the battery (2), a determination unit (5) for determining a current power consumption (P) of the vacuum cleaner (3), a calculation unit (6) for calculating the remaining running time (T; T1, T2, T3) as a function of the currently available electrical energy (E) detected and the current power consumption (P) determined, and a display unit (7) for displaying the calculated remaining running time (T; T1, T2, T3) as plain text (K),
**characterised in that** the determination unit (5) is set up to determine the current power consumption (P) of the vacuum cleaner (3) as a function of a discrete set power level of the power regulator of the vacuum cleaner (3).

**2.** Device according to claim 1, **characterised in that** a control device (8) is provided which integrates the detection unit (4), the determination unit (5) and the calculation unit (6).

**3.** Device according to claim 2, **characterised in that** the control device (8) has a look-up table (9) which stores a plurality of mappings from a respective determined value pair comprising the electrical energy (E) of the battery (2) and the power consumption (P) of the vacuum cleaner (3) to a respective determined remaining running time (T; T1, T2, T3).

**4.** Device according to claim 3, **characterised in that** the control device (8) is set up to detect a current state of charge of the battery (2) at a first time point, to detect the electrical energy (E) currently available from the battery (2) at the first time point from the detected current state of charge, to measure an on-time of the vacuum cleaner (3) between the first time point and a second time point, to determine the remaining running time (T1) at the first time point by means of the look-up table (9), the detected currently available electrical energy (E) at the first time point and the determined current power consumption (P) at the first time point, and to calculate the remaining running time (T2) at the second time point using a difference between the determined remaining running time (T1) at the first time point and the measured on-time.

**5.** Device according to one of claims 1 to 4, **characterised in that** the display device (7) is set up to display the calculated remaining running time (T; T1, T2, T3) as a numeric value.

**6.** Device according to one of claims 1 to 5, **characterised in that** the display device (7) has an LCD display.

**7.** Device according to one of claims 1 to 6, **characterised in that** the detection unit (4) is set up to detect the energy (E) currently available from the battery (2) as a function of a measured voltage of the battery (2) during operation of the vacuum cleaner (3).

**8.** Device according to claim 7, **characterised in that** the detection unit (4) is set up to detect the energy (E) currently available from the battery (2) as a function of the measured voltage of the battery (2) and a measured current of the battery (2) during operation of the vacuum cleaner (3).

**9.** Device according to one of claims 1 to 8, **characterised in that** the determination unit (5) is set up to determine the current power consumption (P) of the vacuum cleaner (3) as a function of a measured voltage of a motor (10) of the vacuum cleaner (3) and a measured current of the motor (10).

**10.** Device according to one of claims 1 to 9, **characterised in that** the display device (7) is set up to display the calculated remaining running time (T; T1, T2, T3) and an associated discrete power level (P) of the power regulator of the vacuum cleaner (3).

**11.** Device according to one of claims 1 to 10, **characterised in that** the calculation unit (6) is set up to calculate a respective remaining running time (T1, T2, T3) for a respective associated discrete power level (S1, S2, S3) of a plurality of discrete power levels (S1, S2, S3) of the power regulator, and that the display device (7) is set up to display the respective calculated remaining running time (T1, T2, T3) with the respective associated discrete power level (S1, S2, S3).

12. Vacuum cleaner (3) with a device (1) for displaying a remaining running time (T; T1, T2, T3) of a battery (2) of the vacuum cleaner (3) according to one of claims 1 to 11.

**Revendications**

1. Dispositif (1) destiné à l'affichage d'un temps de marche restant (T ; T1, T2, T3) d'un aspirateur (3) fonctionnant au moyen d'un accumulateur (2), comprenant une unité de détection (4) pour détecter une énergie (E) électrique momentanément disponible de l'accumulateur (2), une unité de détermination (5) pour déterminer une absorption de puissance momentanée (P) de l'aspirateur (3), une unité de calcul (6) pour calculer le temps de marche restant (T ; T1, T2, T3) en fonction de l'énergie électrique (E) momentanément disponible calculée et de l'absorption de puissance (P) momentanée déterminée, et comprenant un dispositif d'affichage (7) pour afficher le temps de marche restant calculé (T ; T1, T2, T3) en texte clair, **caractérisé en ce que** l'unité de détermination (5) est configurée pour déterminer l'absorption de puissance momentanée (P) de l'aspirateur (3) en fonction d'un étage de puissance discret réglé du régulateur de puissance de l'aspirateur (3).

2. Dispositif selon la revendication 1, **caractérisé en ce qu'**un dispositif de commande (8) est ménagé, lequel intègre l'unité de détection (4), l'unité de détermination (5) et l'unité de calcul (6).

3. Dispositif selon la revendication 2, **caractérisé en ce que** le dispositif de commande (8) présente une table de consultation (9) laquelle mémorise une pluralité d'attributions d'une paire de valeurs respective déterminée de l'énergie électrique (E) de l'accumulateur (2) et de l'absorption de puissance (P) de l'aspirateur (3) à un temps de marche restant respectif déterminé (T ; T1, T2, T3).

4. Dispositif selon la revendication 3, **caractérisé en ce que** le dispositif de commande (8) est configuré pour détecter un état de charge momentané de l'accumulateur (2) à un premier moment, pour détecter l'énergie électrique (E) momentanément disponible de l'accumulateur (2) au premier moment à partir de l'état de charge momentané détecté, pour mesurer une durée de fonctionnement de l'aspirateur (3) entre le premier moment et un deuxième moment, pour déterminer le temps de marche restant (T1) au premier moment au moyen de la table de consultation (9), au moyen de l'énergie électrique (E) disponible, momentanément détectée, au premier moment et au moyen de l'absorption de puissance (P) momentanée déterminée au premier moment, et pour calculer le temps de marche restant (T2) au deuxième moment par une différence entre le temps de marche restant déterminé (T1) au premier moment et la durée de fonctionnement mesurée.

5. Dispositif selon l'une quelconque des revendications 1 à 4, **caractérisé en ce que** le dispositif d'affichage (7) est configuré pour afficher le temps de marche restant calculé (T ; T1, T2, T3) en tant qu'une valeur numérique.

6. Dispositif selon l'une quelconque des revendications 1 à 5, **caractérisé en ce que** le dispositif d'affichage (7) présente un écran LCD.

7. Dispositif selon l'une quelconque des revendications 1 à 6, **caractérisé en ce que** l'unité de détection (4) est configurée pour détecter l'énergie (E) momentanée disponible de l'accumulateur (2) en fonction d'une tension mesurée de l'accumulateur (2) pendant le fonctionnement de l'aspirateur (3).

8. Dispositif selon la revendication 7, **caractérisé en ce que** l'unité de détection (4) est configurée pour détecter l'énergie (E) momentanée disponible de l'accumulateur (2) en fonction de la tension mesurée de l'accumulateur (2) et d'un courant mesuré de l'accumulateur (2) pendant le fonctionnement de l'aspirateur (3).

9. Dispositif selon l'une quelconque des revendications 1 à 8, **caractérisé en ce que** l'unité de détermination (5) est configurée pour déterminer l'absorption de puissance momentanée (P) de l'aspirateur (3) en fonction d'une tension mesurée d'un moteur (10) de l'aspirateur (3) et d'un courant mesuré du moteur (10).

10. Dispositif selon l'une quelconque des revendications 1 à 9, **caractérisé en ce que** le dispositif d'affichage (7) est configuré pour afficher le temps de marche restant calculé (T ; T1, T2, T3) et un étage de puissance (P) discret correspondant du régulateur de puissance de l'aspirateur (3).

11. Dispositif selon l'une quelconque des revendications 1 à 10, **caractérisé en ce que** l'unité de calcul (6) est configurée pour calculer un temps de marche restant respectif (T1, T2, T3) pour un étage de puissance (S1, S2, S3) discret respectif correspondant d'une pluralité d'étages de puissance discrets (S1, S2, S3) du régulateur de puissance, et **en ce que** le dispositif d'affichage (7) est configuré pour afficher le temps de marche restant (T1, T2, T3) respectif calculé avec l'étage de puissance (S1, S2, S3) discret respectif correspondant.

12. Aspirateur (3) comprenant un dispositif (1) destiné à afficher un temps de marche restant (T ; T1, T2, T3) d'un accumulateur (2) de l'aspirateur (3) selon l'une quelconque des revendications 1 à 11.

EP 2 750 576 B1

Fig. 1

10

Fig. 2

Fig. 3

Fig. 4

Fig. 5

17

1

Fig. 6

701

702

703

704

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080133054 A1
- KR 102006064330 A

- JP 2011102806 A